# EUROPÄISCHE PATENTSCHRIFT

(11) **EP 1 917 568 B1**
(45) Veröffentlichungstag und Bekanntmachung des Hinweises auf die Patenterteilung: **29.02.2012**
(21) Anmeldenummer: 06777918.1
(22) Anmeldetag: 24.07.2006
(51) Int. Cl.: G05F 1/575, H01L 41/04

(54) **STROMQUELLE UND STEUERVORRICHTUNG**
CURRENT SOURCE AND CONTROL DEVICE
SOURCE DE COURANT ET DISPOSITIF DE COMMANDE

(30) Priorität: 26.08.2005 DE 102005040532
(43) Veröffentlichungstag der Anmeldung: 07.05.2008
(73) Patentinhaber: Continental Automotive GmbH, 30165 Hannover (DE)
(72) Erfinder: SCHMAUSS, Harald, 93098 Scheuer (DE); SCHROD, Walter, 93057 Regensburg (DE)
(86) Internationale Anmeldenummer: PCT/EP2006/064558
(87) Internationale Veröffentlichungsnummer: WO 2007/023053

(56) Entgegenhaltungen:
- WO-A-90/15922
- DE-A1- 10 331 057
- DE-A1-102004 030 249
- DE-A1-102004 054 109
- US-B2- 6 859 022

## Beschreibung

Die Erfindung betrifft eine Stromquelle und eine Steuervorrichtung. Derartige Stromquellen werden insbesondere eingesetzt in einer Steuervorrichtung, die insbesondere vorgesehen ist zum Einsatz für einen oder mehrere Piezoaktuatoren.

Immer strengere gesetzliche Vorschriften bezüglich der zulässigen Schadstoff-Emissionen von Brennkraftmaschinen, die in Kraftfahrzeugen angeordnet sind, machen es erforderlich diverse Maßnahmen vorzunehmen, durch die die Schadstoff-Emissionen gesenkt werden. Ein Ansatzpunkt hierbei ist, die während des Verbrennungsprozesses des Luft/KraftstoffGemisches erzeugten Schadstoff-Emissionen zu senken. Insbesondere die Bildung von Ruß ist stark abhängig von der Aufbereitung des Luft/Kraftstoff-Gemisches in dem jeweiligen Zylinder der Brennkraftmaschine. Um eine sehr gute Gemischaufbereitung zu erreichen, wird Kraftstoff zunehmend unter sehr hohem Druck zugemessen. Im Falle von Diesel-Brennkraftmaschinen betragen die Kraftstoffdrücke bis zu 2000 bar. Für derartige Anwendungen setzen sich zunehmend Einspritzventile durch mit einem Piezoaktuator als Stellantrieb. Piezoaktuatoren zeichnen sich aus durch sehr kurze Ansprechzeiten. Derartige Einspritzventile sind so gegebenenfalls geeignet mehrfach innerhalb eines Arbeitszyklusses eines Zylinders der Brennkraftmaschine Kraftstoff zuzumessen.

Eine besonders gute Gemischaufbereitung lässt sich erreichen, wenn vor einer Haupteinspritzung eine oder mehrere Voreinspritzungen erfolgen, die auch als Piloteinspritzung bezeichnet werden, wobei für die einzelne Voreinspritzung gegebenenfalls eine sehr geringe Kraftstoffmasse zugemessen werden soll. Ein präzises Ansteuern des Einspritzventils ist insbesondere für diese Fälle sehr wichtig.

Eine wichtige Rolle kommt im Zusammenhang mit dem präzisen Ansteuern des Einspritzventils dem Laden und Entladen des Piezoaktuators zu. Zu diesem Zweck ist regelmäßig eine Leistungsendstufe vorgesehen, die jedoch während des Entladevorgangs den Piezoaktuator nicht vollständig entladen kann oder dies unter den geforderten und zur Verfügung stehenden Zeitdauern nicht leisten kann. Zum vollständigen Entladen ist diesbezüglich dann ein Schaltelement vorgesehen, das diese Aufgabe übernehmen kann, dabei jedoch thermischen Belastungen unterliegt. Das Schaltelement ist Teil einer Stromsenke, die auch als Stromquelle bezeichnet werden kann.

Die US 6 859 022 B2 offenbart eine Stromquelle die abhängig von einem Strom durch ein Schaltelement und abhängig von einer Spannung über dem Schaltelement einen Betrag eines Ausgangsstroms durch das Schaltelement regelt.

Die WO90/15922 offenbart eine Schaltungsanordnung zum Betrieb von elektromagnetischen Verbrauchern. Zur Erzielung einer möglichst kleinen Verlustleistung wird vorgeschlagen, mindestens zwei unabhängig voneinander steuerbare Schaltglieder vorzusehen, die unterschiedliche große Spannungen an den Verbraucher legen. Der Zeitpunkt für das Anlegen der zweiten Spannung nach dem Anliegen der ersten Spannung ist jedoch fest vorgegeben.

Die DE 10 2004 030 249 A1 und die DE 10 204 054 109 A1 offenbaren jeweils Vorrichtungen zur Ansteuerung eines kapazitiven Lastelements mit geregelter Entladung.

Die DE 103 31 057 A1 offenbart eine Stromquelle mittels derer eine vorgegebene Ladungsmenge auf einen oder mehrere Piezoaktuatoren aufgebracht werden kann.

Die Aufgabe der Erfindung ist es, eine Stromquelle und Steuervorrichtung zu schaffen, die einfach und zuverlässig ist.

Die Aufgabe wird gelöst durch die Merkmale der unabhängigen Patentansprüche. Vorteilhafte Ausgestaltungen der Erfindung sind in den Unteransprüchen gekennzeichnet.

Die Erfindung zeichnet sich aus durch eine Stromquelle mit einem ersten Schaltelement, das einen Steuereingang hat und so ausgebildet und angeordnet ist, dass abhängig von einem Steuersignal an seinem Steuereingang ein Ausgangsstrom ausgangsseitig der Stromquelle einstellbar ist. Ein Referenz-Widerstand ist so mit dem ersten Schaltelement elektrisch gekoppelt, dass ein Spannungsabfall über dem Referenz-Widerstand repräsentativ ist für den Ausgangsstrom. Eine Reglereinheit ist vorgesehen, deren Stellsignal abhängt von dem Spannungsabfall über dem Referenz-Widerstand. Das Stellsignal der Reglereinheit ist das Steuersignal des ersten Schaltelements. Sie umfasst ein Zeitglied, das einen ersten Betrag des Ausgangsstroms auf eine maximale Zeitdauer begrenzt und anschließend den Betrag des Ausgangsstroms reduziert, wobei die maximale Zeitdauer abhängig von einem Integral des Ausgangsstroms ist. Bei geeigneter Vorgabe der maximalen Zeitdauer kann so für die maximale Zeitdauer ein hoher Betrag des Ausgangsstroms eingestellt werden, ohne das erste Schaltelement thermisch zu beschädigen. Ferner ist das erste Schaltelement im Falle eines Kurzschlusses am Ausgang der Stromquelle auf ein Versorgungspotenzial vor thermischer Zerstörung durch die nach der maximalen Zeitdauer eintretende Reduzierung des Betrags des Ausgangsstroms besser geschützt. Insbesondere kann so durch eine geeignete Reduktion des Ausgangsstroms ein sehr hoher Schutz vor thermischer Zerstörung sichergestellt werden und zwar ohne hohen schaltungstechnischen Aufwand, und damit ist eine sehr kostengünstige Stromquelle möglich. So ist die Stromquelle insbesondere kurzschlussfest bezüglich ihres Ausgangs. Im Hinblick auf die Steuervorrichtung wird die Erfindung durch den Einsatz einer solchen Stromquelle gelöst. So kann auch bei zwischenzeitlicher Abschaltung des Ausgangsstroms zuverlässig eine thermische Überlastung des ersten Schaltelements vermieden werden.

Gemäß einer weiteren vorteilhaften Ausgestaltung der Stromquelle ist der erste Betrag des Ausgangsstroms nach einer vorgegebenen Entspannzeitdauer wieder einstellbar. Dies hat den Vorteil, dass bei geeigneter Wahl der Entspannzeitdauer so sehr schnell wieder der erste Betrag eingestellt werden kann und zugleich eine thermische Beschädigung des ersten Schaltelements vermieden werden kann.

Gemäß einer weiteren vorteilhaften Ausgestaltung der Stromquelle ist sie so ausgebildet, dass die Entspannzeitdauer beginnt bei Wegfall einer externen Quelle, die den Ausgangsstrom treibt. Eine derartige externe Quelle kann beispielsweise ein Piezoaktuator sein oder auch eine Spannungsquelle, wie zum Beispiel eine Bordnetzversorgung. So ist insbesondere ein gezieltes und kurzschlussfeste Entladen des Piezoaktuators besonders zuverlässig möglich.

Gemäß einer weiteren vorteilhaften Ausgestaltung der Stromquelle umfasst das Zeitglied ein RC-Glied, das durch einen elektrischen in Serie angeordneten Widerstand und eine Kapazität gebildet ist. Das RC-Glied ist elektrisch parallel zu dem Referenz-Widerstand angeordnet. Ein Steuereingang eines Zeitglied-Schaltelements ist elektrisch gekoppelt mit einem Abgriffspunkt des RC-Glieds, der elektrisch zwischen dem Widerstand und der Kapazität des RC-Glieds liegt. Das Zeitglied-Schaltelement ist so angeordnet, dass es abhängig von seinem Steuersignal das Stellsignal der Reglereinheit beeinflusst. Auf diese Weise ist das Zeitglied besonders einfach ausgebildet.

Gemäß einer weiteren vorteilhaften Ausgestaltung der Stromquelle umfasst das Zeitglied einen Widerstand und ein Hilfszeitglied-Schaltelement, die elektrisch in Serie angeordnet sind. Mittels des Hilfszeitglied-Schaltelements ist der Widerstand elektrisch parallel schaltbar zu dem Referenz-Widerstand. Ein Steuereingang eines weiteren Zeitglied-Schaltelements ist elektrisch gekoppelt mit einem Abgriffspunkt, der elektrisch zwischen dem Widerstand und dem Hilfszeitglied-Schaltelement liegt. Das weitere Zeitglied-Schaltelement ist so angeordnet, dass es abhängig von seinem Steuersignal das Stellsignal der Reglereinheit beeinflusst. So ist eine einfache schaltungstechnische Realisierung möglich.

In diesem Zusammenhang ist es besonders vorteilhaft, wenn ein Steuerausgang einer Steuereinheit elektrisch gekoppelt ist mit einem Steuereingang des Hilfszeitglied-Schaltelements. So kann dieser Steuereingang einfach genutzt werden und gegebenenfalls auch andere Einflussgrößen beim Einstellen der maximalen Zeitdauer oder gegebenenfalls der Entspannzeitdauer berücksichtigt werden.

Ausführungsbeispiele der Erfindung sind im Folgenden anhand der schematischen Zeichnungen erläutert. Es zeigen:
- Figur 1: ein Einspritzventil mit einer Steuervorrichtung umfassend eine Stromquelle,
- Figur 2: eine genauere Darstellung der Steuervorrichtung mit der Stromquelle und
- Figur 3: eine weitere Ausführungsform der Stromquelle.

Elemente gleicher Konstruktion oder Funktion sind figurenübergreifend mit den gleichen Bezugszeichen gekennzeichnet.

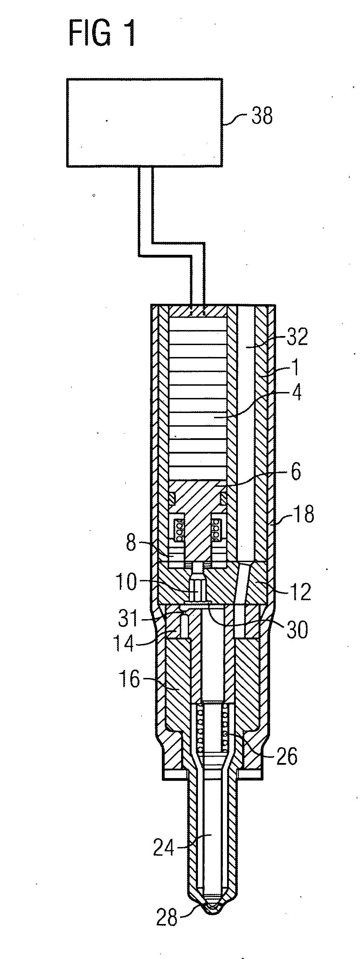

Ein Einspritzventil (Figur 1) hat ein Injektorgehäuse 1 mit einer Ausnehmung, in die ein Piezoaktuator PAKT1, also ein Piezo-Stellantrieb, eingesetzt ist, der mit einem Übertrager 6 gekoppelt ist. Der Übertrager 6 ist in einem Leckageraum 8 angeordnet. Ein Schaltventil 10, das bevorzugt als Servoventil ausgebildet ist, ist so angeordnet, dass es abhängig von seiner Schaltstellung ein Leckagefluid absteuert, das in dieser Ausführungsform bevorzugt der Kraftstoff ist. Das Schaltventil ist über den Übertrager 6 mit dem Piezoaktuator PAKT 1 gekoppelt und wird von ihm angetrieben, das heißt die Schaltstellung des Schaltventils 10 wird mittels des Piezoaktuators PAKT 1 eingestellt. Gegebenenfalls kann der Piezoaktuator PAKT 1 auch ohne Zwischenschaltung des Übertragers 6 auf das Schaltventils 10 einwirken. Das Schaltventil 10 ist in einer Ventilplatte 12 angeordnet. Es umfasst ein Ventilglied, dessen Position mittels des Piezoaktuators PAKT 1 einstellbar ist und das in einer Schaltstellung in Anlage ist mit der Ventilplatte und so das Absteuern von Kraftstoff in den Leckageraum verhindert. In einer weiteren Schaltstellung ist es beabstandet zu einer Wandung der Ventilplatte 12 und ermöglicht so das Absteuern des Kraftstoffs in den Leckageraum 8. Der Piezoaktuator umfasst einen Stapel 60 von Piezoelementen. Der Stapel 60 der Piezoelemente umfasst zum Beispiel etwa 200 Piezoelemente, die aufeinander geschichtet sind. Der Stapel 60 der Piezoelemente ist bevorzugt von einer Rohrfeder umgeben, die den Stapel 60 der Piezoelemente zwischen den Übertrager 6 und einem Abschlusselement einspannt.

Das Einspritzventil umfasst ferner einen Nadelführungskörper 14 und einen Düsenkörper 16. Die Ventilplatte 12, der Nadelführungskörper 14 und der Düsenkörper 16 bilden eine Düsenbaugruppe, die mittels einer Düsenspannmutter 18 an dem Injektorgehäuse 1 befestigt ist.

Der Nadelführungskörper 14 hat eine Ausnehmung, die als Ausnehmung des Düsenkörpers 16 in dem Düsenkörper 16 fortgesetzt ist und in der eine Düsennadel 24 angeordnet ist. Die Düsennadel 24 ist in dem Nadelführungskörper 14 geführt. Eine Düsenfeder 26 spannt die Düsennadel 24 in eine Schließposition vor, in der sie einen Kraftstofffluss durch ein Einspritzloch 28 unterbindet.

An dem axialen Ende der Düsennadel 24, das hingewandt ist zu der Ventilplatte 12, ist ein Steuerraum 30 ausgebildet, der über eine Zulaufdrossel 31 mit einer Hochdruckbohrung 32 hydraulisch gekoppelt ist. Befindet sich das Schaltventil 10 in seiner Schließposition, so ist der Steuerraum 30 hydraulisch entkoppelt von dem Leckageraum 8. Dies hat zur Folge, dass sich nach einem Schließen des Schaltventils 10 der Druck in dem Steuerraum 30 im wesentlichen dem Druck in der Hochdruckbohrung 32 angleicht. Die Hochdruckbohrung 32 ist beim Einsatz des Einspritzventils in einer Brennkraftmaschine mit einem Kraftstoffhochdruckspeicher hydraulisch gekoppelt und wird so mit Kraftstoff unter einem Druck von beispielsweise bis zu 2000 bar versorgt.

Über den Steuerraum 30 wird aufgrund des Fluiddrucks in dem Steuerraum 30 auf eine Stirnfläche der Düsennadel 24 eine Kraft in Schließrichtung der Düsennadel 24 ausgeübt. Die Düsennadel 24 weist ferner axial beabstandet zu ihrer Stirnfläche einen Absatz auf, der mit Fluid, das durch die Hochdruckbohrung 32 strömt, derart beaufschlagt wird, dass eine öffnend wirkende Kraft auf die Düsennadel 24 wirkt, also entgegen der Schließrichtung. In ihrer Schließposition unterbindet die Düsennadel 24 einen Kraftstofffluss durch die Einspritzdüse 28. Bewegt sich die Düsennadel 24 ausgehend von ihrer Schließposition hinein in den Steuerraum 30, so gibt sie den Kraftstofffluss durch die Einspritzdüse 28 frei, insbesondere in ihrer Offenposition, in der sie in Anlage mit dem Bereich der Wandung des Steuerraums 30 ist, der durch die Ventilplatte 12 gebildet wird.

Ob die Düsennadel 24 sich in ihrer Offenposition oder in ihrer Schließposition befindet hängt davon ab, ob die Kraft, die an dem Absatz der Düsennadel 24 durch den dort herrschenden Druck des Fluids hervorgerufen wird, größer oder kleiner ist als die Kraft, die durch die Düsenfeder 26 und den auf die Stirnfläche der Düsennadel 24 einwirkenden Druck hervorgerufen wird.

Befindet sich das Schaltventil 10 in seiner Offenposition, so strömt Fluid von dem Steuerraum 30 durch das Schaltventil 10 hinein in den Leckageraum 8. Bei geeigneter Dimensionierung der Zulaufdrossel sinkt dann der Druck in dem Steuerraum 30, was schließlich zu einer Bewegung der Düsennadel in ihre Offenposition führt. Der Druck des Fluids in dem Leckageraum 8 ist deutlich geringer als der Druck des Fluids in der Hochdruckbohrung.

Eine Steuervorrichtung 38 ist dem Einspritzventil zugeordnet. Die Steuervorrichtung 38 ist ausgebildet zum Erzeugen eines Stellsignals SG für den Piezoaktuator PAKT1 des Einspritzventils. Die Steuervorrichtung 38 ist bevorzugt ferner ausgebildet zum Erzeugen von Stellsignalen für weitere Piezoaktuatoren PAKT2-4, die weiteren Einspritzventilen zugeordnet sind.

Das Stellsignal SG ist bevorzugt ein Stromsignal, das bevorzugt pulshöhenmoduliert ist. Ausgehend von einem Start eines Ladevorgangs wird bevorzugt eine vorgegebene Anzahl Pulse, so zum Beispiel 20, mit einer vorgegebenen zeitlichen Dauer und Periode erzeugt, bis der Ladevorgang abgeschlossen ist. Über die Höhe des jeweiligen Pulses wird die während des Ladevorgangs dem Piezoaktuator PAKT 1 zuzuführende elektrische Energie eingestellt. Die dem Piezoaktuator PAKT 1 während eines Ladevorgangs LV zuzuführende Energie wird abhängig von Betriebsparametern ermittelt. Die dem Piezoaktuator PAKT 1 zugeführte Energie beeinflusst dessen axialen Hub und somit auch den Verlauf des Drucks in dem Steuerraum 30.

Die Steuervorrichtung 38 ist ferner ausgebildet zum Durchführen eines Entladevorgangs des Piezoaktuators PAKT 1. Bevorzugt wird dazu eine vorgegebene Anzahl an Entladepulsen erzeugt, so z.B. 20, mit einer vorgegebenen zeitlichen Dauer und Periode. Über die Höhe der jeweiligen Entladepulse wird die während des Entladevorgangs dem Piezoaktuator PAKT 1 entnommene elektrische Energie eingestellt. Die dem Aktuator entnommene Energie beeinflusst dessen axiale Hub-Verringerung.

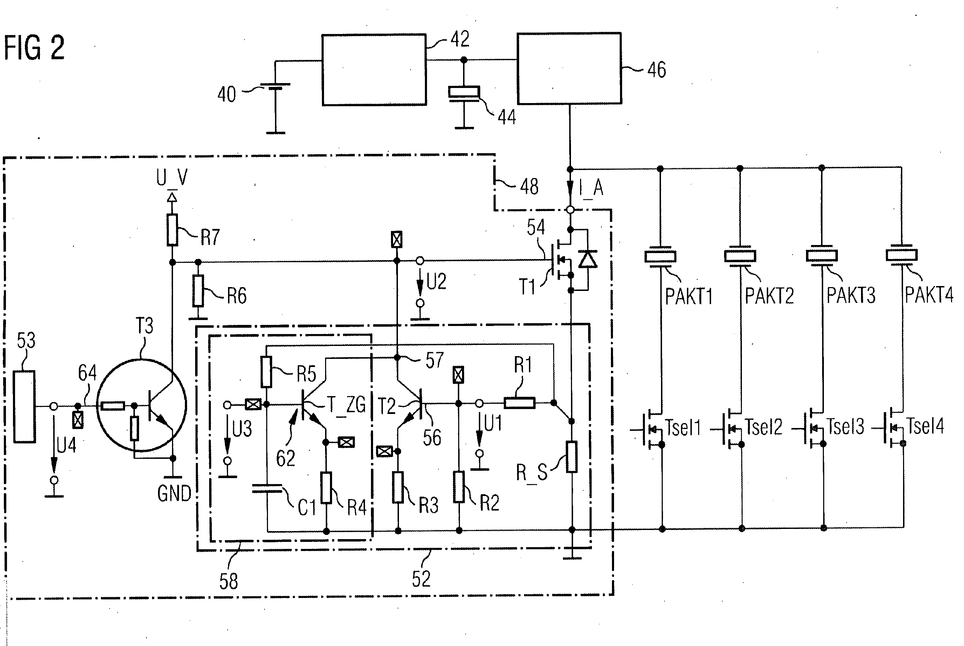

Ein Teil der Steuervorrichtung 38 ist anhand der Figur 2 dargestellt. Die Steuervorrichtung 38 umfasst einen Spannungsverstärker 42, der auch als DC/DC-Wandler bezeichnet ist, und der mit einem Bordnetz 40 elektrisch gekoppelt ist, das ausgebildet ist zum Versorgen des Spannungsverstärkers 42 mit einer vorgegebenen Spannung und so eine Spannungsquelle bildet. Das Bordnetz umfasst beispielsweise eine Fahrzeugbatterie.

Der Spannungsverstärker 42 ist elektrisch mit einer Leistungsendstufe 46 gekoppelt. Bevorzugt ist ein Kondensator 44 zwischengeschaltet und zwar derart, dass in dem Kondensator 44 elektrische Energie bei dem Entladevorgang der jeweiligen Piezoaktuatoren PAKT1 bis PAKT4 zwischengespeichert werden kann und für zukünftige Ladevorgänge eingesetzt werden kann.

Die Leistungsendstufe 46 der Steuervorrichtung 38 ist elektrisch gekoppelt mit den Piezoaktuatoren PAKT1 bis PAKT4, die separat zu der Steuervorrichtung 38 ausgebildet sind und zwar in den Einspritzventilen. Bevorzugt ist aus Kostengründen eine Leistungsendstufe 46 mehreren Piezoaktuatoren PAKT1 bis PAKT4 zugeordnet. Die Auswahl des jeweils zu ladenden oder entladenden Piezoaktuators PAKT1 bis PAKT4 erfolgt bevorzugt über Auswahlschaltelemente TSEL1 bis TSEL4.

Bei einem Entladevorgang, der durch die Leistungsendstufe 46 gesteuert ist, verbleibt nach der vorgegebenen Anzahl an Entladepulsen noch eine Restladung in dem jeweiligen Piezoaktuator PAKT1 bis PAKT4. Soll auch diese Restladung von dem jeweiligen Piezoaktuator PAKT1 bis PAKT4 abgeführt werden, so wird eine Stromquelle 48 der Steuervorrichtung 38 aktiviert, die zu diesem Zweck vorgesehen ist.

Die Stromquelle 48 umfasst eine Reglereinheit 52 und ein erstes Schaltelement T1. Das erste Schaltelement T1 ist so ausgebildet und angeordnet, dass abhängig von einem Steuersignal an einem Steuereingang 54 des ersten Schaltelements T1 ein Ausgangsstrom I_A ausgangsseitig der Stromquelle 48-einstellbar ist. Der Ausgangsstrom I_A stellt sich in der eingezeichneten Stromrichtung ein. Er stellt einen Entladestrom für den jeweiligen Piezoaktuator PAKT1 bis PAKT4 dar. Während des Betriebs erzeugt die Reglereinheit 52 an ihrem Ausgang ein Stellsignal, das das Steuersignal des ersten Schaltelements T1 ist.

Die Stromquelle 48 umfasst ferner einen Referenz-Widerstand R_S, der so mit dem ersten Schaltelement T1 elektrisch gekoppelt ist, dass ein Spannungsabfall über dem Referenz-Widerstand R_S repräsentativ ist für den Ausgangsstrom I_A. Elektrisch parallel zu dem Referenz-Widerstand R_S ist ein Spannungsteiler umfassend Widerstände R1 und R2 angeordnet. Ein Steuereingang 56 eines zweiten Schaltelements T2 ist elektrisch gekoppelt mit einem Abgriffspunkt, der elektrisch zwischen den Widerständen R1 und R2 liegt. Somit ist der Steuereingang des zweiten Schaltelements T2 mit einem Steuersignal beaufschlagt, das bevorzugt eine Spannung U1 ist.

Das zweite Schaltelement T2 beeinflusst ein Stellsignal der Reglereinheit 52, das als Steuersignal auf den Steuereingang 54 des ersten Schaltelements T1 einwirkt. Bevorzugt ist das zweite Schaltelement ein Bipolartransistor in Emitterschaltung mit Stromgegenkopplung, die durch einen Widerstand R3 erfolgt. Ein Ausgang 57 der Reglereinheit ist sowohl elektrisch gekoppelt mit dem Eingang des ersten Schaltelements T1 als auch mit einem Widerstand R7, der wiederum mit einem Versorgungspotenzial U_V verbunden ist. Der Widerstand R7 wirkt so als Vorwiderstand. Das Schaltelement T2 erzeugt so das Stellsignal für den Steuereingang 54 des ersten Schaltelements abhängig von dem Spannungsabfall über dem Referenz-Widerstand R_S. Insbesondere treibt es einen Strom durch den Widerstand R7, dessen Betrag abhängt von dem Spannungsabfall an dem Referenz-Widerstand R_S. Der Betrag kann eingestellt werden durch die entsprechende Dimensionierung des Spannungsteilers, der durch die Widerstände R1 und R2 gebildet wird, den Widerstand R3 und auch den Widerstand R7 und durch das Versorgungspotenzial U_V.

Der Stromfluss durch den Widerstand R7 führt dann zu einem Spannungsabfall über dem Widerstand R7 und stellt so eine Spannung U2 an dem Steuereingang 54 des ersten Transistors ein, die bevorzugt das Steuersignal an dem Steuereingang 54 des ersten Transistors bildet. Durch eine geeignete Dimensionierung der Widerstände R1, R2, R3, R7 und des ReferenzWiderstands R_S, ferner des zweiten Schaltelements T2 und des ersten Schaltelements T1 und des Versorgungspotenzials U_V kann so ein gewünschter erster Betrag des Ausgangsstroms I_A der Stromquelle 48 eingestellt werden.

Der erste Betrag des Ausgangsstroms kann beispielsweise zwischen 2 und 5 A betragen. Der erste Betrag des Ausgangsstroms I_A führt zu einem hohen Wärmeeintrag in das erste Schaltelement T1. Das erste Schaltelement T1 ist bezüglich seiner Wärmespeicherkapazität und seiner Wärmeabfuhr so dimensioniert, dass es den ersten Betrag des Ausgangsstroms I_A nur für eine begrenzte Zeitdauer ohne die Gefahr einer thermischen Beschädigung aufnehmen kann. Dabei ist es so dimensioniert, dass ein Abführen der Restladung in den jeweiligen Piezoaktuator PAKT1 bis PAKT4 nach Abschluss der vorgegebenen Anzahl der Entladepulse, die durch die Leistungsendstufe 46 gesteuert werden, mittels des ersten Betrags des Ausgangsstroms I_A über die Stromquelle 48 abführen kann.

Zum Ein- und Ausschalten des Ausgangsstroms I_A ist ein drittes Schaltelement T3 vorgesehen, das so betrieben wird, dass abhängig von einem Steuersignal an seinem Steuereingang 64 das Steuersignal des ersten Schaltelements auf einen Abschaltwert gebracht werden kann, indem das erste Schaltelement keinen Fluss des Ausgangsstroms I_A zulässt. Bevorzugt ist dazu das dritte Schaltelement T3 ausgangsseitig elektrisch mit dem Widerstand R7 gekoppelt und kann abhängig von seiner Schaltstellung diesen mit dem Bezugspotenzial GND elektrisch koppeln. Dies hat zur Folge, dass in der Schaltstellung des dritten Schaltelements, in der der Widerstand R7 über das dritte Schaltelement T3 mit dem Bezugspotenzial GND elektrisch gekoppelt ist, die Spannung U2 einen niedrigen Spannungspegel nahe dem Bezugspotenzial GND einnimmt und so das erste Schaltelement T1 sperrt. Befindet sich das dritte Schaltelement T3 hingegen in seiner Schaltstellung, in der es den Widerstand R7 nicht mit einem Bezugspotenzial GND koppelt, so kann durch die Reglereinheit 52 die Spannung U2 eingestellt werden. Das dritte Schaltelement T3 ist bevorzugt mit seinem Steuereingang 64 mit einem Ausgang einer Steuereinheit der Stromquelle oder der Steuervorrichtung elektrisch gekoppelt. Das Steuersignal liegt an dem Steuereingang 64 bevorzugt eine Spannung U4 an.

Die Reglereinheit 52 umfasst ferner ein Zeitglied 58. Das Zeitglied 58 ist dazu ausgebildet, den ersten Betrag des Ausgangsstroms I_A auf eine maximale Zeitdauer zu begrenzen und anschließend den Betrag des Ausgangsstroms I_A zu reduzieren. Das Zeitglied umfasst ein RC-Glied, das eine elektrische Reihenschaltung eines Widerstands R5 und einer Kapazität C1 ist. Das RC-Glied ist elektrisch parallel angeordnet zu dem Referenz-Widerstand R_S. Ferner umfasst das Zeitglied 58 ein Zeitglied-Schaltelement T_ZG, das einen Steuereingang 62 hat, der elektrisch mit dem RC-Glied zwischen dem Widerstand R5 und der Kapazität C1 gekoppelt ist. Bevorzugt liegt so als Stellsignal an dem Steuereingang 62 des Zeitglied-Schaltelements T_ZG eine Spannung U3 an. Ausgangsseitig ist das Zeitglied-Schaltelement T_ZG mit dem Ausgangs 57 der Reglereinheit 52 elektrisch gekoppelt und beeinflusst so das Stellsignal der Reglereinheit und somit das Steuersignal des ersten Schaltelements T1. Das Zeitglied-Schaltelement T_ZG ist bevorzugt ein Bipolartransistor, der in Emitterschaltung angeordnet ist und stromgegengekoppelt ist mittels des Widerstands R4. Er treibt so einen Strom durch den Widerstand R7, der abhängt von der Spannung U3 an seinem Steuereingang 62.

Wenn das dritte Schaltelement T3, ausgehend von seiner Schaltstellung, in der es den Widerstand R7 mit dem Bezugspotenzial GND koppelt, in die Schaltstellung gesteuert wird, in der es den Widerstand R7 von dem Bezugspotenzial entkoppelt, so beginnt sich zunächst der erste Betrag des Ausgangsstroms I_A einzustellen, und zwar geregelt mittels des zweiten Schaltelements T2, und führt zu dem entsprechenden Spannungsabfall über dem Referenz-Widerstand R_S und somit ebenso über dem parallel geschalteten RC-Glied. Dies hat zur Folge, dass sich die Kapazität C1 auflädt, bis die Spannung U3 an dem Steuereingang des Zeitglied-Schaltelements T_ZG zu einem Durchschalten des Zeitglied-Schaltelements führt.

Abhängig von der Spannung U3 an dem Steuereingang 62 des Zeitglied-Schaltelements T_ZG wird so dann der Strom durch den Widerstand R7 ebenfalls beeinflusst und führt damit bei geeigneter Dimensionierung der Kapazität C1 und des Widerstands R5 bzw. auch des Widerstands R4 und R7 und des Referenz-Widerstands R_S zu einer Reduktion des Betrags des Ausgangsstroms I_A.

Durch geeignete Dimensionierung kann so eine maximale Zeitdauer eingestellt werden, während der der Ausgangsstrom den ersten Betrag annehmen kann. Durch das integrierende Verhalten des RC-Glieds kann so auch eine zwischenzeitliche Abschaltung des Ausgangsstroms oder eine zwischenzeitliche Reduktion des Ausgangsstroms berücksichtigt werden. Die maximale Zeitdauer ist dabei geeignet so vorgegeben, dass eine thermische Beschädigung des ersten Schaltelements T1 durch den Wärmeeintrag verhindert werden kann, der durch den ersten Betrag des Ausgangsstroms I_A eingebracht wird.

Durch die Dimensionierung der Bauelements des Zeitglieds 58, also der Widerstände R4, R5, der Kapazität C1 und des Zeitglied-Schaltelements T_ZG kann dann ferner der Betrag der Reduktion des Ausgangsstroms I_A nach Ablauf der maximalen Zeitdauer eingestellt werden und so beispielsweise ein geeigneter geringerer zweiter Betrag des Ausgangsstroms von beispielsweise 100 bis 200 mA eingestellt werden, mittels dessen beispielsweise in einem Fehlerfall der Endstufe ein vollständiges Entladen von einem vollständig geladenen Zustand der jeweiligen Piezoaktuatoren PAKT1 bis PAKT4 möglich ist oder auch bei einem Kurzschluss des Ausgangs der Stromquelle 48 hin zu dem Bordnetz 40 die thermische Zerstörung des ersten Schaltelements T1 zuverlässig vermieden werden kann.

Die durch das Zeitglied 58 hervorgerufene Reduktion des Ausgangsstroms I_A führt jedoch dann auch wieder zu einer Reduktion des Spannungsabfalls über dem Referenz-Widerstand R_S.
Das RC-Glied, der Widerstand R4 und der Referenzwiderstand R_S sind so dimensioniert, dass auch bei durchgeschaltetem Zeitglied-Schaltelement T_ZG die Spannung U3 auf einem Wert bleibt, bei dem das Zeitglied-Schaltelement T_ZG durchgeschaltet bleibt, solange durch eine externe Quelle ein Strom als Ausgangsstrom der Stromquelle getrieben wird. Die externe Quelle kann beispielsweise der jeweilige Piezoaktuator PAKT1 bis PAKT4 oder auch die Spannungsquelle 40 sein.

Eine Entspannzeitdauer beginnt dann erst mit Wegfall der externen Quelle, der auch durch ein Einnehmen der Schaltstellung des dritten Schaltelements T3 verursacht sein kann, in der es den Widerstand R7 mit dem Bezugspotenzial GND koppelt.

Auf diese Weise kann dann so die Entspannzeitdauer geeignet eingestellt werden, nach der dann das Zeitglied-Schaltelement T_ZG wieder sperrt und somit der erste Betrag des Ausgangsstroms wieder eingestellt werden kann. Durch eine geeignete Wahl der Entspannzeitdauer kann dann zum einen möglichst schnell wieder der erste Betrag des Ausgangsstroms I_A eingestellt werden, aber andererseits auch sichergestellt werden, dass das erste Schaltelement T1 thermisch nicht überlastet wird.

Ein Widerstand R6 ist als Schutzbeschaltung vorgesehen.

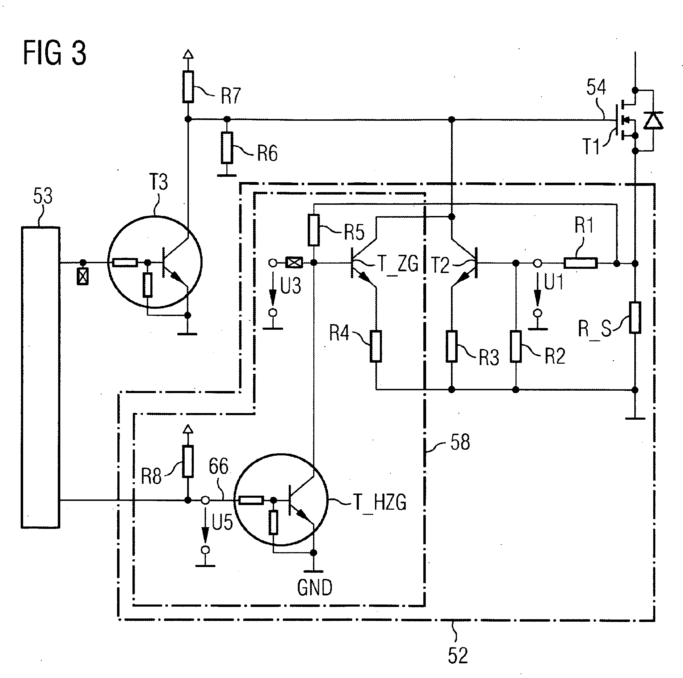

Bei einer zweiten Ausführungsform der Stromquelle 48 (siehe Figur 3) unterscheidet sich das Zeitglied 58 dadurch, dass statt dem RC-Glied der Widerstand R5 in Serie mit einem Hilfszeitglied-Schaltelement T_HZG geschaltet ist und zwar derart, dass der Widerstand R5 elektrisch parallel schaltbar ist zu dem Referenz-Widerstand R_S in einer Schaltstellung des Hilfszeitglied-Schaltelements T_HZG und zwar durch Kopplung mit dem Bezugspotenzial und in einer weiteren Schaltstellung des Hilfszeitglied-Schaltelements T_HZG elektrisch entkoppelt ist von dem Bezugspotenzial GND. In diesem Fall ist ein Steuereingang 66 des Hilfszeitglied-Schaltelements T_HZG bevorzugt mit einem weiteren Ausgang der Steuereinheit elektrisch gekoppelt, der auch als Timer-Ausgang bezeichnet wird, und das Verringern des erstes Betrags kann so dann über entsprechende Steuersignale an dem Steuereingang 66 des Hilfszeitglied-Schaltelements T_HZG eingestellt werden. Dazu ist die Steuereinheit 53 dann bevorzugt geeignet ausgebildet zum Erfassen des Ausgangsstroms I_A oder einer dafür repräsentativen Größe und zum Integrieren und so Ermitteln der entsprechenden maximalen Zeitdauer oder der Entspannzeitdauer. Bevorzugt ist das Steuersignal an dem Steuereingang 66 des Hilfszeitglied-Schaltelements T_HZG eine Spannung U5. Bevorzugt ist ferner ein Widerstand R8 vorgesehen.

## Patentansprüche

1. Stromquelle mit
- einem ersten Schaltelement (T1), das einen Steuereingang (54) hat und so ausgebildet und angeordnet ist, dass abhängig von einem Steuersignal an seinem Steuereingang (54) ein Ausgangsstrom (I_A) ausgangsseitig der Stromquelle (48) einstellbar ist,
- einem Referenz-Widerstand (R_S), der so mit dem ersten Schaltelement (T1) elektrisch gekoppelt ist, dass ein Spannungsabfall über dem Referenz-Widerstand (R_S) repräsentativ ist für den Ausgangsstrom (I_A),
- einer Reglereinheit (52), deren Stellsignal abhängt von dem Spannungsabfall über dem Referenz-Widerstand (R_S), deren Stellsignal das Steuersignal des ersten Schaltelements (T1) ist und die ein Zeitglied (58) umfasst, das einen ersten Betrag des Ausgangsstroms (I_A) auf eine maximale Zeitdauer begrenzt und anschließend den Betrag des Ausgangsstroms (I_A) reduziert, **dadurch gekennzeichnet, dass** die maximale Zeitdauer abhängt von einem Integral des Ausgangsstroms (I_A).

2. Stromquelle nach Anspruch 1, bei der der erste Betrag des Ausgangsstroms (I_A) nach einer vorgegebenen Entspannzeitdauer wieder einstellbar ist.

3. Stromquelle nach Anspruch 2, die so ausgebildet ist, dass die Entspannzeitdauer beginnt bei Wegfall einer externen Quelle, die den Ausgangsstrom (I_A) treibt.

4. Stromquelle nach einem der vorstehenden Ansprüche, bei der das Zeitglied (58) ein RC-Glied umfasst, das durch einen elektrisch in Serie angeordneten Widerstand (R5) und eine Kapazität (C1) gebildet ist, wobei das RC-Glied elektrisch parallel zu dem Referenz-Widerstand (R_S) angeordnet ist, und bei dem ein Steuereingang (62) eines Zeitglied-Schaltelements (T_ZG) elektrisch gekoppelt ist mit einem Abgriffspunkt des RC-Glieds, der elektrisch zwischen dem Widerstand (R5) und der Kapazität (C1) des RC-Glieds liegt, und das Zeitglied-Schaltelement (T_ZG) so angeordnet ist, dass es abhängig von seinem Steuersignal das Stellsignal der Reglereinheit (52) beeinflusst.

5. Stromquelle nach einem der vorstehenden Ansprüche, bei der das Zeitglied (52) elektrisch in Serie angeordnet, ein Widerstand (R5) und ein Hilfszeitglied-Schaltelement (T_HZG) umfasst, wobei mittels des Hilfszeitglied-Schaltelements (T_HZG) der Widerstand (R5) elektrisch parallel schaltbar ist zu dem Referenz-Widerstand (R_S) und ein Steuereingang eines weiteren Zeitglied-Schaltelements (T_ZG) elektrisch gekoppelt ist mit einem Abgriffspunkt, der elektrisch zwischen dem Widerstand (R5) und dem Hilfszeitglied-Schaltelement (T_HZG) liegt, und das weitere Zeitglied-Schaltelement (T_ZG) so angeordnet ist, dass es abhängig von seinem Steuersignal das Stellsignal der Reglereinheit (52) beeinflusst.

6. Stromquelle nach Anspruch 5, bei der ein Steuerausgang einer Steuereinheit (53) elektrisch gekoppelt ist mit einem Steuereingang des Hilfszeitglied-Schaltelements (T_HZG).

7. Steuervorrichtung mit einer Stromquelle (48) nach einem der vorstehenden Ansprüche, die vorgesehen ist zum Steuern eines Piezoaktuators (PAKT1 bis PAKT4), wobei die Stromquelle (48) so mit dem Piezoaktuator (PAKT1 bis PAKT4) koppelbar ist, dass sie den Piezoaktuator (PAKT1 bis PAKT4) entladen kann, und wobei sie eine Leistungsendstufe (46) zum Laden und Entladen des Piezoaktuators (PAKT1 bis PAKT4) aufweist, die elektrisch parallel zu der Stromquelle (48) angeordnet ist.

## Claims

1. Current source having
- a first switching element (T1) which has a control input (54) and is embodied and arranged in such a way that an output current (I A) on the output side of the current source (48) can be set as a function of a control signal at its control input (54),
- a reference resistor (R_S) which is electrically coupled to the first switching element (T1) in such a way that a voltage drop across the reference resistor (R S) is representative of the output current (I_A),
- a regulator unit (52) having an actuating signal which is dependent on the voltage drop across the reference resistor (R_S), its actuating signal being the control signal of the first switching element (T1), and including a timing relay (58) which limits a first magnitude of the output current (I A) to a maximum time period and subsequently reduces the magnitude of the output current (I_A), **characterised in that** the maximum time period is dependent on an integral of the output current (I_A).

2. Current source according to claim 1, wherein the first magnitude of the output current (I_A) can be reset after a predefined relaxation time period.

3. Current source according to claim 2, which is embodied in such a way that the relaxation time period starts when an external source which drives the output current (I A) is removed.

4. Current source according to one of the preceding claims, wherein the timing relay (58) comprises an RC element which is formed by a resistor (R5) and a capacitor (C1) arranged electrically in series, with the RC element being arranged electrically in parallel with the reference resistor (R_S), and wherein a control input (62) of a timing relay switching element (T_ZG) is electrically coupled to a tapping point of the RC element which is located electrically between the resistor (R5) and the capacitor (C1) of the RC element, and wherein the timing relay switching element (T_ZG) is arranged in such a way that it influences the actuating signal of the regulator unit (52) as a function of its control signal.

5. Current source according to one of the preceding claims, wherein the timing relay (52) is arranged electrically in series, comprises a resistor (R5) and an auxiliary timing relay switching element (T_HZG), with the resistor (R5) being able to be switched electrically in parallel with the reference resistor (R S) by means of the auxiliary timing relay switching element (T_HZG), and a control input of a further timing relay switching element (T_ZG) is electrically coupled to a tapping point which is located electrically between the resistor (R5) and the auxiliary timing relay switching element (T_HZG), and the further timing relay switching element (T_ZG) is arranged in such a way that it influences the actuating signal of the regulator unit (52) as a function of its control signal.

6. Current source according to claim 5, wherein a control output of a control unit (53) is electrically coupled to a control input of the auxiliary timing relay switching element (T_HZG).

7. Control device having a current source (48) according to one of the preceding claims, which control device is provided for controlling a piezoelectric actuator (PAKT1 to PAKT4), wherein the current source (48) can be coupled to the piezoelectric actuator (PAKT1 to PAKT4) in such a way that it can discharge the piezoelectric actuator (PAKT1 to PAKT4), and wherein the control device comprises a power output stage (46) which is provided for charging and discharging the piezoelectric actuator (PAKT1 to PAKT4) and is arranged electrically in parallel with the current source (48).

## Revendications

1. Source de courant, comprenant :
- un premier élément de commutation (T1) qui a une entrée de commande (54) et qui est conformé et agencé de sorte qu'en fonction d'un signal de commande à son entrée de commande (54), un courant de sortie (I_A) peut être réglé côté sortie de la source de courant (48),
- une résistance de référence (R S) qui est couplée électriquement au premier élément de commutation (T1) de sorte qu'une chute de tension sur la résistance de référence (R S) est représentative pour le courant de sortie (I_A),
- une unité de régulation (52), dont le signal de réglage dépend de la chute de tension sur la résistance de référence (R_S), dont le signal de réglage est le signal de commande du premier élément de commutation (T1) et comprend un élément temporisateur (58), qui limite une première valeur du courant de sortie (I_A) à une période de temps maximale et réduit ensuite la valeur du courant de sortie (I_A), **caractérisée en ce que** la période de temps maximale dépend d'une intégrale du courant de sortie (I_A).

2. Source de courant selon la revendication 1, dans laquelle la première valeur du courant de sortie (I_A) peut être à nouveau réglée après une période de détente prédéfinie.

3. Source de courant selon la revendication 2, qui est conformée de sorte que la période de détente démarre à la disparition d'une suppression d'une source externe qui entraîne le courant de sortie (I_A).

4. Source de courant selon l'une quelconque des revendications précédentes, dans laquelle l'élément temporisateur (58) comprend un élément RC, qui est formé d'une résistance (R5) agencée électriquement en série et d'une capacité (C1), où l'élément RC est agencé de manière électriquement parallèle à la résistance de référence (R S), et où une entrée de commande (62) d'un élément de commutation d'élément temporisateur (T_ZG) est couplée électriquement à un point de prélèvement de l'élément RC, qui se situe électriquement entre la résistance (R5) et la capacité (C1) de l'élément RC, et où l'élément de commutation d'élément temporisateur (T_ZG) est agencé de sorte qu'il influence le signal de réglage de l'unité de régulation (52) en fonction de son signal de commande.

5. Source de courant selon l'une quelconque des revendications précédentes, dans laquelle l'élément temporisateur (52) est agencé électriquement en série et comprend une résistance (R5) et un élément de commutation d'élément temporisateur de secours (T_HZG), dans laquelle, au moyen de l'élément de commutation d'élément temporisateur de secours (T_HZG), la résistance (R5) peut être commutée de manière électriquement parallèle à la résistance de référence (R S) et une entrée de commande d'un autre élément de commutation d'élément temporisateur (T_ZG) est couplé électriquement à un point de prélèvement, qui se situe électriquement entre la résistance (R5) et l'élément de commutation d'élément temporisateur de secours (T_HZG), et où l'autre élément de commutation d'élément temporisateur (T_ZG) est agencé de sorte qu'il influence le signal de réglage de l'unité de régulation (52) en fonction de son signal de commande.

6. Source de courant selon la revendication 5, dans laquelle une sortie de commande d'une unité de commande (53) est couplée électriquement à une entrée de commande de l'élément de commutation d'élément temporisateur de secours (T_HZG).

7. Dispositif de commande d'une source de courant (48) selon l'une quelconque des revendications précédentes, qui est prévu pour commander un actionneur piézoélectrique (PAKT1 à PAKT4), dans lequel la source de courant (48) peut être couplée à l'actionneur piézoélectrique (PAKT1 à PAKT4) de sorte qu'elle peut décharger l'actionneur piézoélectrique (PAKT1 à PAKT4) et dans laquelle elle présente un étage de sortie de puissance (46) pour le chargement et le déchargement de l'actionneur piézoélectrique (PAKT1 à PAKT4), qui est agencé de manière électriquement parallèle à la source de courant (48).
